# EUROPEAN PATENT APPLICATION

(11) **EP 1 170 886 A2**
(43) Date of publication of application: **09.01.2002**
(21) Application number: 01116063.7
(22) Date of filing: 02.07.2001
(51) Int. Cl.: H04B 10/10

(54) **Control and communication system for components of electrical apparatus**

(30) Priority: 06.07.2000 GB 0016500
(71) Applicant: Pace Micro Technology PLC, Saltaire, Shipley, BD18 3LF (GB)
(72) Inventor: Coe, Peter W., North Yorkshire, BD23 2TE (GB)
(74) Representative: Wood, Graham

(57) **Abstract**

Electrical apparatus, such as a printed circuit board for a broadcast data receiver, is provided. The apparatus includes a number of components (4; 12) which are required to be interconnected in a manner to allow the transmission of data therebetween. At least two of these components (4; 12) are provided with communication means to allow communication of data and the communication means are in the form of a light emitter and receiver.

## Description

This invention relates to a means for allowing communication between components within electrical apparatus and thus control of said components. The invention can be of use with any form of electrical apparatus, and one such form is a receiver for the reception of broadcast data and decoding/processing of the same. Although the following description refers to a broadcast data receiver, it should be appreciated that the invention is not limited to this particular form of apparatus in any way.

In most broadcast data receivers there are at least four functional circuit blocks interactively communicating with each other using two or three wire buses. If any of these functional blocks are in locations in the broadcast data receiver (BDR) sensitive to electrical interference, individual wire buses are required. Thus for example, for four functional blocks employing two wire buses, eight printed circuit board (PCB) tracks from eight pins of one or more controlling circuits are required. These PCB tracks, typically of copper, connect the relevant parts of the functional blocks on the PCB together. The tracks are typically long in order to physically separate the functional blocks so that electrical interference is reduced. In line filtering can be employed to electrically reduce conducted interference between two blocks and individual bus driving is employed in order that each wire bus can be electrically switched off, thereby reducing the level of electrical interference. However, a problem with this is that use of individual bus drive systems defeats one of the main purposes of the bus system, in that it was intended that all functional blocks would use a common bus and not individual buses. Another problem with using a number of buses is the significant amount of copper track connections used between the buses.

It is found that as much as 60% of the copper on a PCB within a broadcast data receiver is used for communication between components. This also means that due to the restrictive layout of PCBs, it is often the case that a multi-layer PCB configuration is required to be adopted in the receiver rather than a double sided PCB, as the PCB track layout which is required cannot be fitted into the allocated space. Utilisation of multi-layer PCB configurations means that the cost of the receiver can increase and this is undesirable.

A further problem is that in addition to conducted electrical interference, in the PCB of the receiver interference is radiated due to track lengths and source load mismatch of the connecting tracks. PCBs that carry high speed data such as memory buses and MPEG bit streams account for more than 50% of all the tracks on a PCB. Digital pulses with rise and fall times of a few nano seconds produce radiated and conducted electrical signals of several hundred MHz, and this is the main source of Electro Magnetic Compatibility (EMC) and Radio Frequency Interference (RFI) problems encountered in receivers. These problems are usually overcome by employing a number of EMC or RFI electrical and mechanical "fixes" in the BDR in order to make the BDR comply with International Standards and operationally acceptable. These "fixes" typically increase the cost of manufacturing the BDR.

The aim of the present invention is to provide a means whereby at least two components of the PCB can be connected to allow the transmission of data between the two without or with reduced electrical interference.

A further aim of the present invention is to allow communication between the components in a manner which ensures that the overall configuration of the apparatus can be in as cost effective a manner as possible.

In a first aspect of the invention there is provided electrical apparatus, said electrical apparatus including a number of components which are required to communicate with each other in a manner to allow the transmission of data therebetween, and characterised in that at least two of the components are provided with communication means to allow said communication of data in the form of a light emitter and receiver, and communication is made by the controlled emission of light and the reception of the same.

In one embodiment the communication means comprise what are hereinafter referred to as a 'light aerial' for the transmission and reception of data. In this embodiment the communication means includes a series of LED's and Photo receptors which are provided to communicate with each other. This communication is achieved by allowing the light to radiate from the LED's and throughout a housing of the electrical apparatus in which the components are provided.

In an alternative embodiment light data signals can be transmitted from one component to the other via a conduit, such as a fibre optic cable connection.

Preferably the electrical apparatus is a broadcast data receiver.

In one embodiment infra red (IF) light emitters and transmitters are used. For example, on a dual satellite tuner BDR the two tuners are controlled by two independent I²C buses (i.e., with in line filters and eight PCB tracks). Two IR transceivers are required, one transceiver is required for the controller IC and one transceiver is required for the two tuners. The slow data rate of IR transceivers is suitable for such I²C bus systems. The addition of further IR transceivers or receive only devices for other components conventionally suffering from electrical interference, such as the TV re-modulator and the SCART switch functions, can also be employed.

In a second aspect of the present invention there is provided a BDR, said BDR receiving digital data from a broadcaster at a remote location and decoding said data to provide video, audio and/or auxiliary data, said BDR including one or more printed circuit boards and said one or boards including a number of components which are required to be interconnected in a manner to allow the transmission of data therebetween, characterised in that at least two of said components are provided with communication means to allow said communication of data and said communication means are in the form of a light emitter and receiver.

The advantages of employing a light communication method are that conducted electrical interference normally associated with copper PCB tracks is not present. The light communication method allows single or double-sided PCBs to be used rather than multi layer PCBs and reduces the EMC/RFI fixing required, thereby reducing the cost of manufacturing the BDR or apparatus. In addition, if the light communication method is employed as part of the silicon, i.e., a window is available in the IC package such that it is able to transmit/receive light directly on the silicon die, then again the cost of manufacturing the BDR/apparatus is significantly reduced.

The light communication method does not require a line of sight transmission path as communication distances within broadcast data receivers, and also other electrical equipment, are generally small and there are many surfaces against which the light can be reflected. Signal attenuation is not a problem with the light method as again the communication distances are small. In addition, multi-path interference is not an issue as multi path interference is short in duration compared with the data transmission rate.

A yet further advantage of the present invention is the provision of being able to electrically isolate two circuit paths. As both high and low speed light connectivity can be employed within a BDR/apparatus using the light method, there is no longer the need to physically connect electrical interference generation circuits to electrical interference sensitive circuits. As such, in accordance with the present invention, it is possible to have all the interface circuits, which are the most susceptible circuits to electrical interference, on the rear panel, connected to the digital panels, which are generally the source of electrical interference, near the front of the BDR. This is not typically possible with conventional circuitry.

Specific embodiments of the invention are now described with reference to the accompanying diagrams; wherein
Figure 1 illustrates a first embodiment of the invention; and
Figure 2 illustrates a second embodiment of the invention.

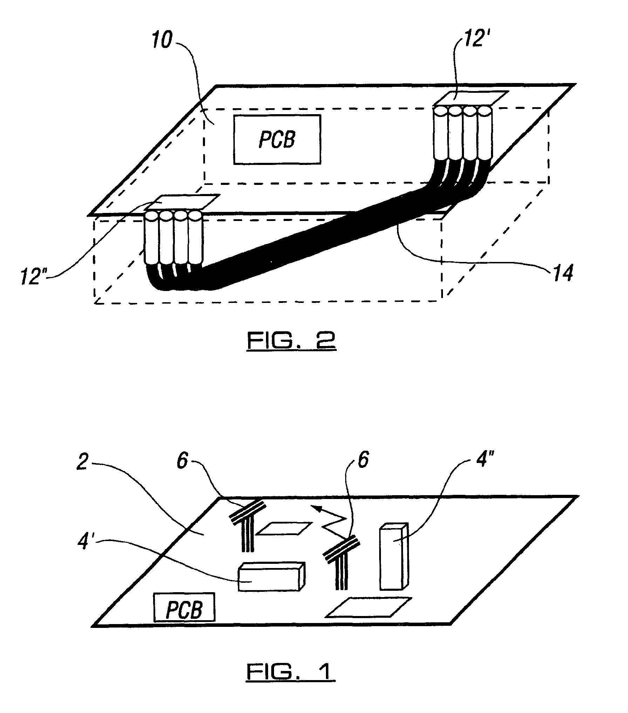

Referring firstly to Figure 1, there is illustrated a first embodiment of the invention wherein there is shown a printed circuit board (PCB) of the type which can be used in a BDR. The PCB 2 has a number of components 4 mounted thereon for illustrative purposes. In practice there will be many more components than is shown.

Two of these components 4',4" are required to be connected to allow the communication of data therebetween and in accordance with this embodiment this is achieved by the provision of what are referred to as light aerials 6 for each of the components 4', 4". If data is required to be transmitted from both components then each aerial is provided with at least one light source such as an LED which is controllable to emit light at required times. In this embodiment the emitted light is free to pass around the BDR housing (not shown) and deflect off the walls, sides, lid, PCB and associated components, and/or floor of the BDR housing, which when fitted encloses the components and forms the external surface of the BDR.

While it is possible that this method may suffer from multi path confusion and interference, signal attenuation, which will be high, is not considered important over such small distances, and the signal attenuation can be compensated for with little effect on the required signal to noise ratio. It may also be necessary to use a large number of light wavelengths in this embodiment with a different wavelength being used for each different data signal communication.

To receive the light which is emitted, each aerial or component is provided with light detecting and receiving means, such as a photo receptor. The photo receptor is set to receive and process light which is transmitted at a certain specified wavelength such that the correct data is received and can then be processed. This therefore allows the appropriate data to be processed and communication between the correct components to be achieved.

In an alternative embodiment as shown in Figure 2, a PCB 10 is provided with components 12', 12" mounted thereon. These two components are required to be interconnected to allow the transmission of data between the same. This embodiment is particularly suited to high data rate transmission where directional signal transmission is required to avoid multi-path problems.

In the reception of multi path signals one digital pulse arrives several times. In low data rate cases, this is not a problem as the duration of the pulse is longer than any multi-path signal. However, in high data rate cases the duration of the pulse may be in the order of the multi path signal, such that it is unclear as to the length of the original digital signal. Therefore, a level of directivity is required and in this embodiment the light data signals are routed along fibre optic type conduits 14. If the light conduits are made into a " light mat" which is placed under but in contact with the bottom side of the components as shown in Figure 2, then it is possible to totally replace the MPG PCB tracks. The light mat comprises a plurality of crossing over conduits which join together appropriate components. In use the light transceivers are placed on the top side of the PCB over holes or slots provided in the PCB and through which they emit the light signals into one of the light channels or conduits 14. Again the high signal attenuation due to light to conduit transfer can be compensated for. Replacement of the PCB tracks greatly reduces the cost of manufacture of the device.

The ICs can have the light transceivers already built into the silicon, the cost increase due to additional light devices is small in comparison to the cost of the large and complex packages currently employed to allow a large number of tracks out from the IC (i.e., board grid arrays, quad flat package and/or the like). In addition, the light output through a window in the silicon has no dimensional restriction and can use the third dimension of the package, compared to conventional PCBs where the PCB tracks restrict the package to two dimensions.

Thus the present invention provides several key advantages in comparison to the conventional use of copper track. These advantages include higher data transfer rates using light, a reduction in copper track layout problems which allows the use of double-sided PCBs instead of the current requirement for multilayer layer PCBs, and the significant reduction in PCB layout time and expenditure. A further advantage is a significant reduction in electrical radiated signal emissions and a higher dynamic range and higher interference signal immunity.

It is thus envisaged that the use of light communication means will be of significant benefit as the complexity of copper tracking is set to increases due to even greater levels of silicon component integration and the need for increased layers of PCB's increases.

## Claims

1. Electrical apparatus, said electrical apparatus including a number of components (4; 12) which are required to communicate with each other in a manner to allow the transmission of data therebetween, and **characterised in that** at least two of the components are provided with communication means to allow said communication of data in the form of a light emitter and receiver, and communication is made by the controlled emission of light and reception of the same.

2. Electrical apparatus according to claim 1 **characterised in that** one or more of the components (4; 12) are provided with light transceivers.

3. Electrical apparatus according to claim 1 **characterised in that** the light emitter and/or receiver is in the form an infra red emitter and/or receiver.

4. Electrical apparatus according to claim 1 **characterised in that** a light aerial (6) is used for the transmission and reception of data.

5. Electrical apparatus according to claim 4 **characterised in that** the light aerials (6) comprise a series of LEDs and photoreceptors which communicate with each other.

6. Electrical apparatus according to claim 1 **characterised in that** light signals can be transmitted between said components via a conduit (14).

7. Electrical apparatus according to claim 6 **characterised in that** said light conduit (14) is a fibre optic cable connection.

8. Electrical apparatus according to claim 6 **characterised in that** said light conduits (14) are made into mats.

9. Electrical apparatus according to claim 8 **characterised in that** said mats are comprised of a plurality of light conduits (14) joining appropriate components (4; 12) together.

10. Electrical apparatus according to claim 8 **characterised in that** the mats are located under but in contact with the components (4; 12).

11. Electrical apparatus according to claim 2 **characterised in that** the light transceivers are built into the silicon and light is transmitted from the silicon through a window provided therein.

12. Electrical apparatus according to claim 1 **characterised in that** said apparatus is a broadcast data receiver, said receiver for receiving digital data broadcast from a broadcaster at a remote location.

13. A broadcast data receiver (BDR), said BDR receiving digital data from a broadcaster at a remote location and decoding said data to provide video, audio and/or auxiliary data, said BDR including one or more printed circuit boards (2; 10) and said one or boards including a number of components (4; 12) which are required to be interconnected in a manner to allow the transmission of data therebetween, **characterised in that** at least two of said components are provided with communication means to allow said communication of data and said communication means are in the form of a light emitter and receiver.
